# EUROPEAN PATENT APPLICATION

(11) **EP 4 852 622 A1**
(43) Date of publication of application: **09.12.2026**
(21) Application number: 25749133.2
(22) Date of filing: 22.01.2025
(51) Int. Cl.: H05K 1/02, H05K 3/00

(54) **PRINTED CIRCUIT BOARD**

(30) Priority: 29.01.2024 KR 20240013333; 28.03.2024 KR 20240042655
(71) Applicant: Yura Corporation Co., Ltd., Seongnam-si, Gyeonggi-do 13494 (KR)
(72) Inventor: KANG, Byung Kwan, Gwangju-si, Gyeonggi-do 12787 (KR); JUNG, Gil Woo, Seongnam-si, Gyeonggi-do 13494 (KR)
(74) Representative: ABG Intellectual Property Law, S.L.
(86) International application number: PCT/KR2025/001226
(87) International publication number: WO 2025/165046

(57) **Abstract**

A printed circuit board according to an embodiment of the present disclosure includes a substrate portion, an electronic component, and a component reinforcement part. The substrate portion includes a circuit layer disposed between first and second insulating layers. The electronic component is mounted in an exposed region where the circuit layer is exposed by removing a portion of the first insulating layer. The component reinforcement part is attached to the second insulating layer in the exposed region and is configured to support the electronic component. The component reinforcement part includes a component reinforcement plate bonded to the second insulating layer of the exposed region, a component adhesive layer formed between the second insulating layer and the component reinforcement plate, and a discharge path configured to discharge an air bubble within the component adhesive layer. The substrate portion further includes a pattern fuse part in which a portion of the circuit layer is formed to function as a fuse, and the pattern fuse part includes a fusible portion configured to melt faster than other parts of the circuit layer at or above a predetermined current. Accordingly, lifting of the electronic component may be prevented, and reliability and durability of the product may be improved.

## Description

### TECHNICAL FIELD

The present disclosure relates to a printed circuit board, and more particularly, to a printed circuit board in which an internal circuit is printed and electrically connected with other components to complete a circuit.

### BACKGROUND ART

A printed circuit board is a circuit board on which an internal circuit is patterned and printed to fix and connect a plurality of electronic components in a standardized manner, and it realizes miniaturization and weight reduction of electronic products by mechanically and electrically coupling a plurality of circuits.

A printed circuit board has advantages in that circuit characteristics are stabilized, there is no concern of incorrect wiring, and the production cost is low. Due to these various advantages, the printed circuit board is used in various fields and is becoming an essential core component used in all electronic devices. In particular, the use of flexible printed circuit boards has recently been increasing in line with the trend of miniaturization and weight reduction.

On one side of such a printed circuit board, electronic components such as connectors and terminals are mounted and connected to respective circuits. To prevent damage to the printed circuit board, particularly a flexible printed circuit board, a reinforcement plate is attached to the other side using an adhesive. However, when soldering is performed for the electrical connection between the electronic components and the respective circuits, the temperature rise from the soldering causes air bubbles within the adhesive to expand. This has caused a problem in that the stability of the electrical connection with the electronic components may be significantly degraded, and defects may occur as the flatness is reduced.

Therefore, there is an increasing demand for a lighter printed circuit board that can stably accommodate various electronic components.

### DISCLOSURE OF THE INVENTION

### TECHNICAL PROBLEM

An embodiment of the present disclosure has been devised to solve the above-mentioned problems, and an object thereof is to provide a lightweight printed circuit board having improved product reliability and productivity.

### TECHNICAL SOLUTION

To solve the above problem, an embodiment of the present disclosure provides a printed circuit board comprising: a substrate portion in which first and second insulating layers are formed on both sides, and a circuit layer is formed between the first and second insulating layers; an electronic component mounted in an exposed region where the circuit layer is exposed by removing a portion of the first insulating layer; and a component reinforcement part attached to the second insulating layer of the exposed region and configured to support the electronic component. The component reinforcement part comprises a component reinforcement plate bonded to the second insulating layer of the exposed region, a component adhesive layer formed between the second insulating layer and the component reinforcement plate, and a discharge path configured to discharge an air bubble within the component adhesive layer. The substrate portion further comprises a pattern fuse part in which a portion of the circuit layer is formed to function as a fuse, and the pattern fuse part comprises a fusible portion configured to melt faster than other parts of the circuit layer at or above a predetermined current.

The electronic component may be formed with a connection portion configured to be electrically connected by soldering to the circuit layer exposed in the exposed region, and the discharge path may be formed at a position corresponding to the connection portion.

The discharge path may be effectively formed as an air tunnel in which the component adhesive layer is removed from a position of the connection portion to one side end of the exposed region.

The discharge path may be formed as an air hole that penetrates the component reinforcement plate and the component adhesive layer at a position of the connection portion.

The discharge path may be effectively formed of a horizontal discharge path formed by removing the component adhesive layer at a position of the connection portion, and a vertical discharge path formed to penetrate the component reinforcement plate so as to be in communication with the horizontal discharge path.

In the exposed region, a fixing circuit to which the electronic component is fixed by soldering is formed, and the discharge path is additionally formed at a position corresponding to the fixing circuit.

The pattern fuse part preferably further comprises connection pads formed at both ends of the fusible portion.

The width of the connection pads is effectively greater than a width of the fusible portion.

At least one of the first insulating layer or the second insulating layer may not be formed on the connection pads, such that the connection pads may be exposed to an exterior.

A protective coating liquid is effectively applied on the connection pads.

The pattern fuse part may further comprise an interference prevention part surrounding the fusible portion, wherein the interference prevention part is a region from which the circuit layer has been removed.

The pattern fuse part may effectively further comprise a concentrated fusing portion formed by an opening in at least one of the first insulating layer or the second insulating layer over at least a portion of the fusible portion.

Preferably, a protective coating liquid is applied to an open surface of the concentrated fusing portion.

The pattern fuse part may effectively further comprise an overflow prevention part formed as a closed curve surrounding the pattern fuse part and formed to protrude from at least one of the first insulating layer or the second insulating layer.

The pattern fuse part may be implemented to include: a connection wiring connected to one end of the fusible portion; and a connection pad formed to be connected to the connection wiring.

A fuse reinforcement part formed on one side of the pattern fuse part to support the pattern fuse part may be further included, wherein the fuse reinforcement part comprises: a fuse adhesive layer attached to at least one surface of the first and second insulating layers of the pattern fuse part; and a fuse reinforcement plate attached to the fuse adhesive layer.

The fuse adhesive layer may be formed in a region other than a position corresponding to the fusible portion, thereby forming an air gap at the position corresponding to the fusible portion.

The fuse reinforcement part may further include a fuse reinforcement part fixing hole formed to penetrate the fuse reinforcement part.

### ADVANTAGEOUS EFFECTS

According to the problem-solving means of the present disclosure as described above, various effects including the following may be expected. However, it is not required for the present disclosure to achieve all of the following effects.

In the printed circuit board according to an embodiment of the present disclosure, a discharge path configured to discharge an air bubble within the adhesive layer is formed corresponding to the exposed region where the electronic component is mounted. This may prevent lifting of the electronic component and provide a more stable electrical connection with the circuit layer.

In addition, this may prevent the flatness of the circuit board from being degraded by the lifting of the electronic component, which may significantly reduce the defect rate. At the same time, the fixing force of the electronic component may also be secured, thereby improving durability against continuous vibrations from vehicle operation.

Furthermore, in a discharge path of another embodiment, a discharge path penetrating the component reinforcement plate is formed, so that air bubbles generated in the component adhesive layer are immediately removed in a stacking direction, which may maximize the above-described effect.

Moreover, by including the pattern fuse part, an embodiment of the present disclosure may realize a more lightweight printed circuit board compared to one that uses a conventional chip fuse.

In addition, an advantage is that defects in the pattern fuse part may be tested in advance during the manufacturing stage via the connection pads.

Furthermore, by providing the interference prevention part, the concentrated fusing portion, and the overflow prevention part, the reliability of the fusing characteristics of the fusible portion may be increased.

### BRIEF DESCRIPTION OF THE DRAWINGS

FIG. 1 is a schematic diagram of a printed circuit board according to a first embodiment of the present disclosure.
FIG. 2 is an exploded perspective view of portion A of FIG. 1.
FIG. 3(a) is a plan view of the component reinforcement part of portion A of FIG. 1.
FIG. 3(b) is a cross-sectional view of portion A of FIG. 1, taken along line III-III.
FIG. 4(a) is a plan view of a component reinforcement part illustrating a modified example of a discharge path.
FIG. 4(b) is an exploded perspective view of FIG. 4(a).
FIG. 5(a) is a plan view of a component reinforcement part illustrating another modified example of the discharge path of FIG. 1.
FIG. 5(b) is an exploded perspective view of FIG. 5(a).
FIG. 6(a) is a cross-sectional view taken along line VIa-VIa of FIG. 4(a), showing a state in which an electronic component is mounted.
FIG. 6(b) is a cross-sectional view taken along line VIb-VIb of FIG. 5(a), showing a state in which an electronic component is mounted.
FIG. 7 is an enlarged view of the pattern fuse part of FIG. 1.
FIG. 8 is a cross-sectional view taken along line VIII-VIII of FIG. 7.
FIG. 9 is a cross-sectional view taken along line IX-IX of FIG. 7.
FIG. 10 is a plan view illustrating a modified example of the connection pad of FIG. 7.
FIGS. 11 to 14 illustrate a pattern fuse part of a printed circuit board according to a second embodiment.

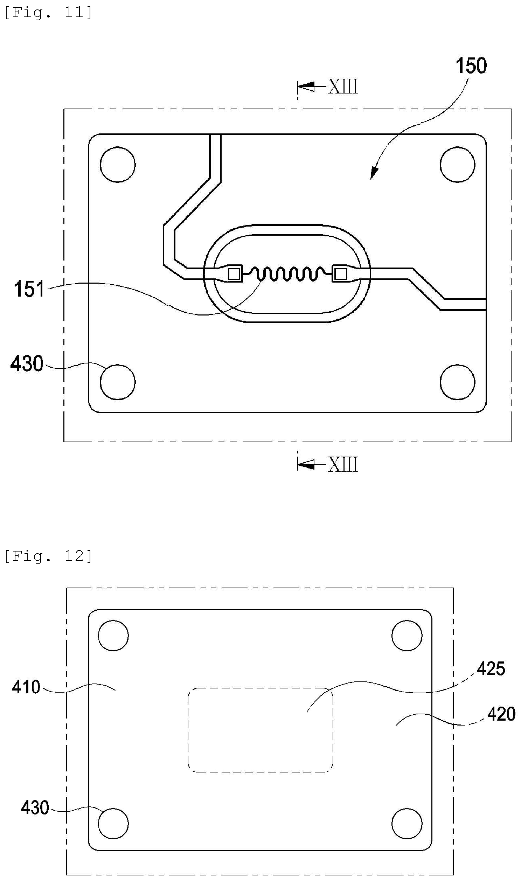

FIG. 11 is a plan view of the pattern fuse part.

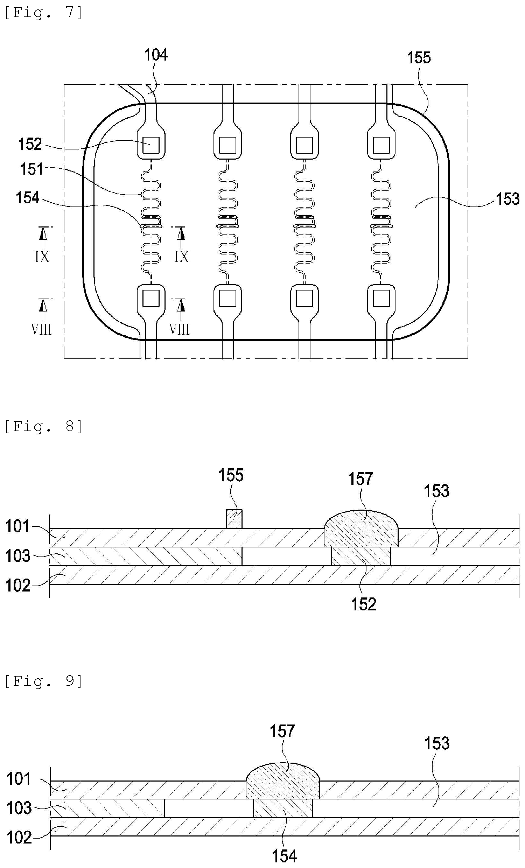

FIG. 12 is a bottom view of FIG. 8.

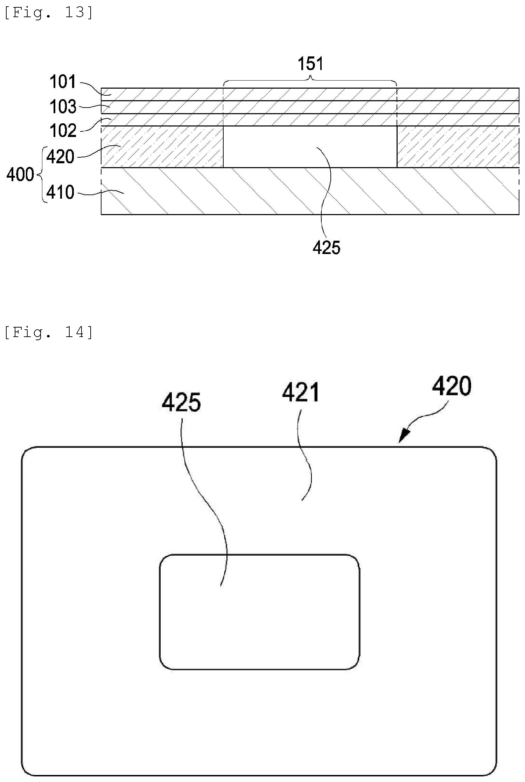

FIG. 13 is a cross-sectional view taken along line XIII-XIII of FIG. 11.
FIG. 14 is a plan view of the adhesive layer of FIG. 11.

### MODE FOR CARRYING OUT THE INVENTION

Hereinafter, specific embodiments of the present disclosure will be described in detail with reference to the accompanying drawings. However, descriptions of well-known functions or configurations will be omitted so as not to obscure the subject matter of the present disclosure.

Furthermore, for convenience of description, a direction in which the printed circuit board extends is defined as an extending direction, a direction in which the insulating layers and the circuit layer are stacked is defined as a stacking direction, a direction in which a connector is mounted is defined as an upper side in the stacking direction, and a direction in which the component reinforcement part is formed is defined as a lower side in the stacking direction.

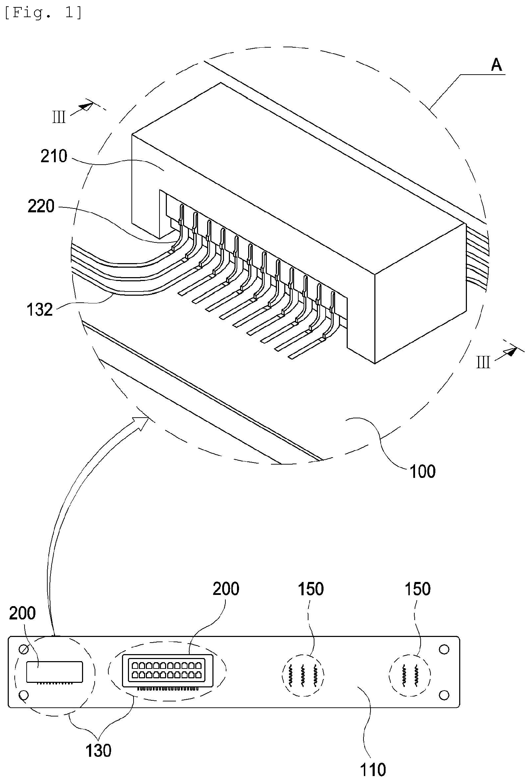

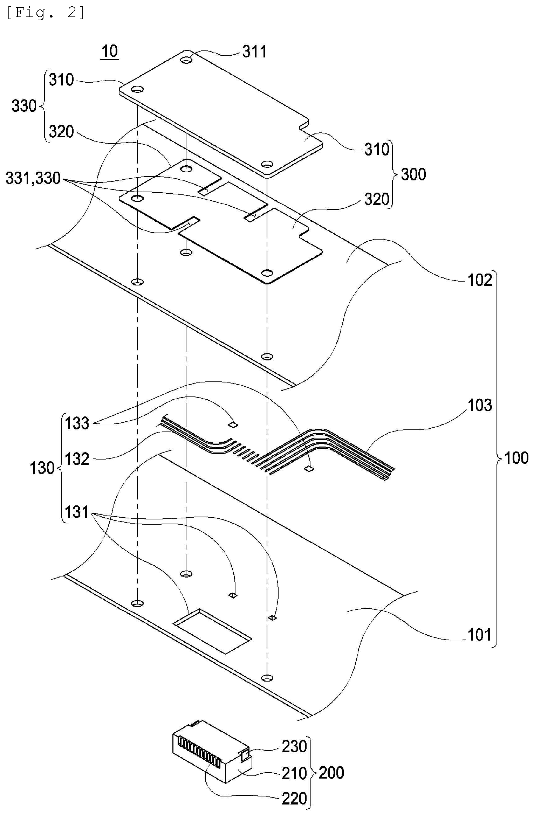

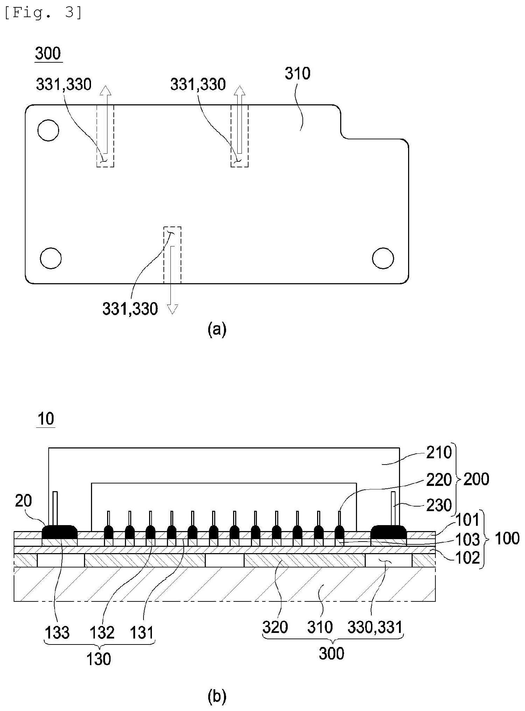

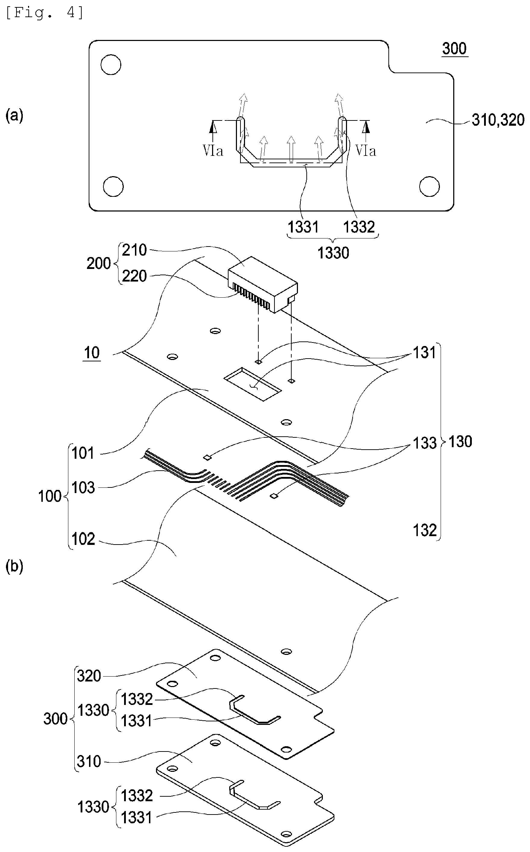

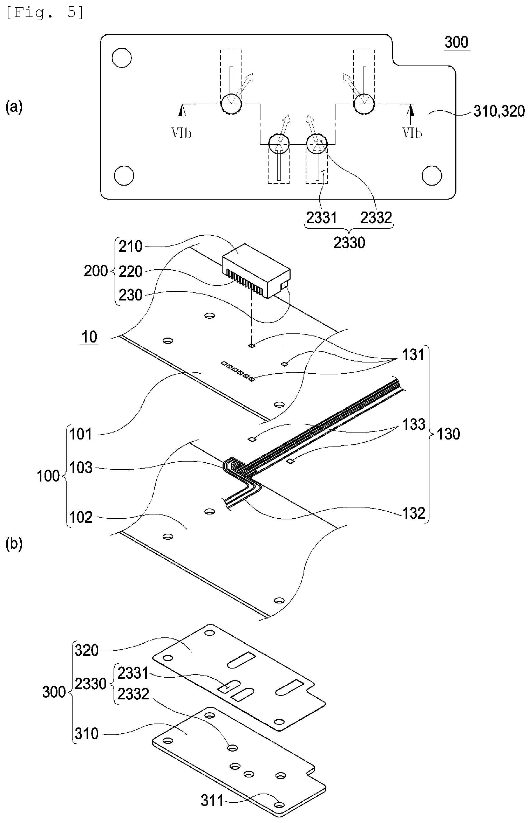

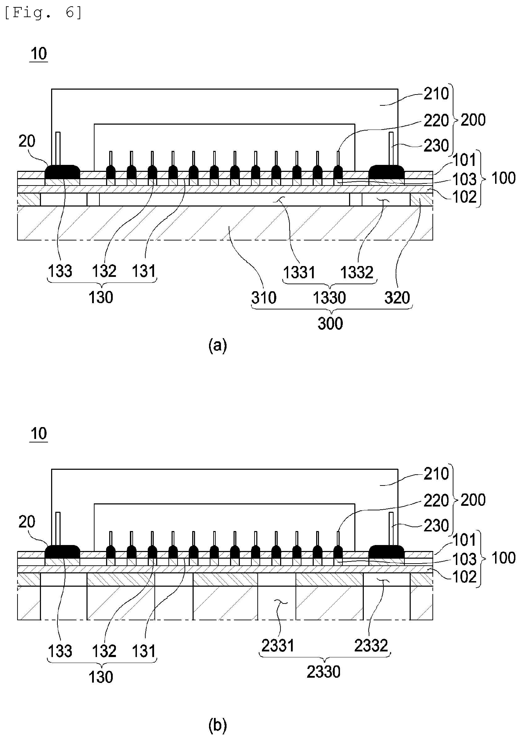

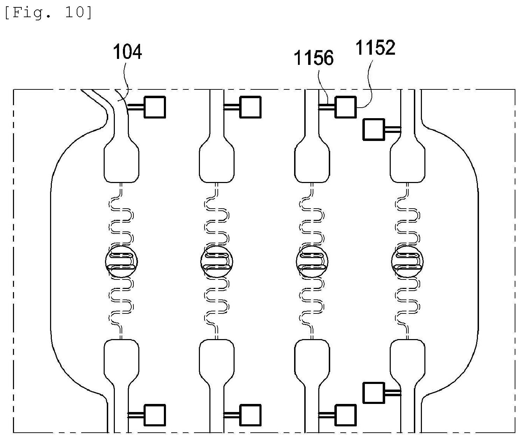

FIG. 1 is a schematic diagram of a printed circuit board according to a first embodiment of the present disclosure; FIG. 2 is an exploded perspective view of portion A of FIG. 1; FIG. 3(a) is a plan view of a component reinforcement part of portion A of FIG. 1; FIG. 3(b) is a cross-sectional view of portion A of FIG. 1, taken along line III-III; FIG. 4(a) is a plan view of a component reinforcement part illustrating a modified example of a discharge path; FIG. 4(b) is an exploded perspective view of FIG. 4(a); FIG. 5(a) is a plan view of a component reinforcement part illustrating another modified example of the discharge path of FIG. 1; FIG. 5(b) is an exploded perspective view of FIG. 5(a); FIG. 6(a) is a cross-sectional view taken along line VIa-VIa of FIG. 4(a), showing a state in which an electronic component is mounted; FIG. 6(b) is a cross-sectional view taken along line VIb-VIb of FIG. 5(a), showing a state in which an electronic component is mounted; FIG. 7 is an enlarged view of a pattern fuse part of FIG. 1; FIG. 8 is a cross-sectional view taken along line VIII-VIII of FIG. 7; FIG. 9 is a cross-sectional view taken along line IX-IX of FIG. 7; and FIG. 10 is a plan view illustrating a modified example of a connection pad of FIG. 7.

Referring to these drawings, a printed circuit board 10 according to an embodiment of the present disclosure comprises a substrate portion 100 in which first and second insulating layers 101 and 102 are formed and a circuit layer 103 is formed between the first and second insulating layers 101 and 102, an electronic component 200 mounted in an exposed region 131 where the circuit layer 103 is exposed by removing a portion of the first insulating layer 101, and a component reinforcement part 300 formed on one side of the exposed region 131 to support the electronic component 200.

In a substrate portion 100, a first insulating layer 101 is stacked on an upper side of a circuit layer 103, in which an internal circuit is formed as a pattern, in a stacking direction, and a second insulating layer 102 is stacked on a lower side of the circuit layer 103 in the stacking direction to electrically connect external components and the circuit layer 103 to complete a plurality of circuits. In this case, the first and second insulating layers 101 and 102 support the circuit layer 103, which is thinly formed, to prevent damage to the internal circuit, such as disconnection, and protect the circuit layer 103 by preventing phenomena such as short circuits with other surrounding components. Therefore, a plurality of internal circuits are formed as a pattern on the circuit layer 103, and the first and second insulating layers 101 and 102 are formed to cover the entire internal circuit from both sides in the stacking direction so that the entire circuit layer 103 is not exposed to an exterior.

The components constituting the substrate portion 100 in the thickness direction have been described above, and hereinafter, each component arranged on a plane and classified according to the shape or function of the substrate portion 100 will be described in more detail.

The substrate portion 100 includes a body portion 110 formed by the aforementioned first and second insulating layers 101 and 102 and the circuit layer 103 in a vertical direction, and, according to function in a horizontal direction, a component mounting portion 130 on which the aforementioned electronic component 200 is mounted, and a pattern fuse part 150 in which a portion of the circuit layer 103 is formed in a shape that can function as a fuse.

The pattern fuse part 150 includes a fusible portion 151 configured to melt faster than other parts of the circuit layer 103 at or above a predetermined current, connection pads 152 formed at both ends of the fusible portion 151, an interference prevention part 153 surrounding the fusible portion 151, wherein the interference prevention part 153 is a region from which the circuit layer 103 has been removed, a concentrated fusing portion 154 in which at least one of the first insulating layer 101 or the second insulating layer 102 is open over at least a portion of the fusible portion 151, and an overflow prevention part 155 formed as a closed curve surrounding the pattern fuse part 150 and formed to protrude from at least one of the first insulating layer 101 or the second insulating layer 102.

The pattern fuse part 150 may be composed of a single fusible portion 151, but as shown in FIG. 7, a plurality of fusible portions 151 may be formed in a cluster. The interference prevention part 153 and the overflow prevention part 155 are formed to surround the entire plurality of fusible portions 151.

The fusible portion 151 is formed to have a smaller cross-sectional area than other circuit traces 104 of the circuit layer 103, so that it melts before the other circuit traces 104 when a current of a predetermined level or higher flows. In addition, as illustrated in FIG. 7, the fusible portion 151 is formed with a narrow line width to increase resistance, and is formed in a zigzag shape to increase its length. A plurality of such fusible portions 151 may be formed. By forming the pattern fuse part 150 as described above, weight may be reduced and manufacturing costs may also be reduced compared to a chip fuse.

The connection pads 152 are formed to have a width greater than a width of the fusible portion 151 and are formed at both ends of the fusible portion 151, respectively. The connection pads 152 are necessary for performance testing of the pattern fuse and are used for resistance testing of the fusible portion 151 during or after the process. Therefore, the connection pads 152 may be continuously exposed, or may be exposed only during the testing stage in the manufacturing process to prevent unnecessary contamination. That is, at least one of the first insulating layer 101 or the second insulating layer 102 on which the connection pads 152 are formed is not formed, such that the connection pads 152 are exposed to an exterior, or as shown in FIG. 8, a protective coating liquid 157 may be applied on top of the connection pads 152 after testing so that the connection pads 152 are not exposed after manufacturing. Alternatively, after testing in a state where only one of the first and second insulating layers 101 and 102 is formed, the remaining insulating layer may be thermally bonded so that the connection pads 152 are not exposed. Since the shape of the connection pads 152 is a test point for resistance measurement, it may be formed in various shapes such as a rectangle, a circle, or a polygon as needed.

In addition, as shown in FIG. 10, the connection pads 152 may be formed separately, rather than being formed directly at both ends of the fusible portion 151. That is, the pattern fuse part 150 may include a connection trace 1156 connected to one end of the fusible portion 151, and a connection pad 1152 formed to be connected to the connection trace 156. The connection pad 1152 is formed at a position spaced apart from the fusible portion 151, and the connection trace 156 connects the fusible portion 151 and the connection pad 1152, thereby allowing the connection pads 152, which occupy a large area, to be disposed outward, which may increase the degree of freedom in design.

The interference prevention part 153 is a region where the circuit layer 103, that is, a conductive conductor, has been removed from an area surrounding the fusible portion 151. By removing the conductive conductor in the area surrounding the fusible portion 151 in this way, the electrical characteristics of the pattern fuse may be maintained constant. If a conductor is present in the fusible portion 151, the electrical characteristics change due to effects such as heat dissipation, so the interference prevention part 153 may prevent such changes.

The concentrated fusing portion 154 is a portion where at least one of the first and second insulating layers 101 and 102 is open over a certain region of the fusible portion 151, for example, a central region. This opening may prevent the fusing characteristics of the fusible portion 151 from being affected by the first and second insulating layers 101 and 102. In addition, to protect the open portion, a protective coating liquid 157 may be applied to an open surface of the concentrated fusing portion 154.

The overflow prevention part 155 is formed to protrude upward on one surface of the first and second insulating layers 101 and 102, that is, the surface to which a protective coating liquid 156 is applied, so as to surround the pattern fuse part 150. The manufacturing method involves forming it to protrude upward from the first and second insulating layers 101 and 102 by a method such as silk-screening. The overflow prevention part 155 prevents the protective coating liquid 157 applied on top of the concentrated fusing portion 154 or the connection pads 152 from overflowing to other parts of the printed circuit board. Alternatively, when applying a coating liquid to the upper surface of the pattern fuse part 150 to secure the performance of the pattern fuse part 150, it provides a guideline for the coating area, prevents coating of unnecessary areas, reduces the required amount of coating liquid, and if the coating liquid overflows, it may be possible to more easily recognize and determine defects.

As described above, an embodiment of the present disclosure includes the pattern fuse part, which may reduce the overall weight compared to when a chip fuse is used.

Furthermore, there is an advantage that defects in the pattern fuse part may be tested in advance during the manufacturing stage through the connection pads.

Furthermore, by including the interference prevention part, the concentrated fusing portion, and the overflow prevention part, the reliability of the fusing characteristics of the fusible portion may be increased.

The component mounting portion 130 includes an exposed region 131 formed by removing a portion of the first insulating layer 101 of the body portion 110, an exposed circuit 132 located in the exposed region 131, where the circuit layer 103 is directly electrically connected to the electronic component 200, and a fixing circuit 133 formed on the circuit layer 103 for fixing the electronic component 200 and exposed by the exposed region 131.

Here, the exposed circuit 132 is formed of copper foil and extends in an extending direction, serving as an exposed portion of an internal circuit of the body portion 110 for electrical connection with the electronic component 200. However, the fixing circuit 133 is formed of the circuit layer 103 in the form of copper foil but is not connected to the internal circuit, and thus is used only for fixing the electronic component 200.

Therefore, the exposed region 131 is formed corresponding to a size of the electronic component 200 to be mounted, and, if necessary, an area where the exposed circuit 132 is exposed and an area where the fixing circuit 133 is exposed may be separately formed. Preferably, a plurality of exposed regions 131 are formed such that each of the exposed circuits 132 and the fixing circuits 133 is partitioned and exposed, thereby minimizing exposure of parts other than the parts connected to the electronic component 200 to enhance the stability of the circuit layer 103.

In summary, a printed circuit board 10 according to an embodiment of the present disclosure forms an exposed region 131 where the circuit layer 103 is exposed in the first insulating layer 101 stacked on one side of the circuit layer 103, and is directly connected to the electronic component 200 to facilitate the formation of a plurality of circuits with an external device.

The electronic component 200 refers to a connector that extends on one side of the printed circuit board 10 and is directly electrically connected to the exposed circuit 131 to relay a connection between an external device and the circuit layer 103, or a sensor, an element, or the like that measures a state of a connected device.

To this end, the electronic component 200 comprises a component body 210, a connection portion 220 exposed on one side of the component body 210 and electrically connected by soldering to each of the exposed circuits 132, and a fixing portion 230 fixed by soldering to the fixing circuit 133.

In this case, the connection portion 220 is formed as a plurality of portions to be connected to a plurality of respective circuits forming the circuit layer 103, thereby forming a plurality of circuits that serve as paths for electrical signals, whereas the fixing portion 230 is exposed on an outer side of the electronic component 200 and is configured to be simply connected to the fixing circuit 133, such that it does not form a circuit even when connected to the fixing circuit 133 by soldering.

The component reinforcement part 300 is attached to the second insulating layer 102 at a position corresponding to the exposed region 131 and supports the electronic component 200, which may prevent damage, such as tearing, to the flexible printed circuit board 10 due to the mounting of the electronic component 200.

The component reinforcement part 300 comprises a component reinforcement plate 310 disposed on the second insulating layer 102 of the exposed region 131, a component adhesive layer 320 formed between the second insulating layer 102 and the component reinforcement plate 310, and a discharge path 330 configured to discharge air bubbles within the component adhesive layer 320. The component reinforcement part 300 supports the mounted electronic component 200 and at the same time may prevent deformation that can occur in the printed circuit board 10 during soldering, thereby improving product reliability and durability.

The component reinforcement plate 310 has rigid physical properties to stably support an electronic component 200 having a certain weight or more, such as a connector, even when mounted. The component reinforcement plate 310 preferably has an area large enough to accommodate all of the plurality of exposed regions 131 to support the entire area of the electronic component 200. A plate fixing hole 311 passes through the component reinforcement plate 310. The plate fixing hole 311 is formed to pass through the component adhesive layer 320 and the substrate portion 100. The plate fixing holes 311 are formed in a number and at positions necessary for fixing the printed circuit board 10. The printed circuit board 10 is fixed when a boss or the like, formed on a counterpart to which the printed circuit board 10 is to be fixed, is inserted into the plate fixing hole 311 and fused thereto.

The component adhesive layer 320 is formed between the second insulating layer 102 and the component reinforcement plate 310 and serves to fix the component reinforcement plate 310 to the second insulating layer 102. The component adhesive layer 320 is formed of a double-sided tape material having a predetermined thickness, and a release liner is attached to both sides before attachment, and the release liner is removed at the time of attachment. The discharge path 330, which is configured to discharge air bubbles from within the component adhesive layer 320, is formed passing through the component adhesive layer 320.

In this process, as the electronic component 200 is mounted by soldering while the component reinforcement plate 310 is attached, the temperature of the exposed region 131 rises. Accordingly, air bubbles within the component adhesive layer 320 expand, causing lifting to occur in the mounting portion of the electronic component 200.

Generally, a reflow soldering process is used for the printed circuit board 10, in which solder paste 20 is preprinted on the exposed region 131, and then external heat is supplied to reflow the solder paste 20 to bond the electronic component 200. The heat supplied in this process has a temperature of approximately 250 °C, and in this case, the volume of the air bubbles within the component adhesive layer 320 expands by approximately two times.

The discharge path 330 is a passage for discharging expanded air bubbles from within the component adhesive layer 320. The discharge path 330 is formed at a position corresponding to the exposed circuit 131, that is, the position of the connection portion 220 where the connection portion 220 of the electronic component 200 is bonded to the circuit layer 103 by soldering, and is in communication with an exterior to discharge the air bubbles to the exterior.

Specifically, in a first embodiment, the discharge path 330 is formed as an air tunnel 331, which is formed by removing the component adhesive layer 320 in a region extending from the positions of the connection portion 220 and the fixing portion 230 to one side end of the component adhesive layer 320. When the temperature rises due to soldering, air bubbles within the component adhesive layer 320 expand and merge with other nearby air bubbles, gradually increasing in size. At this time, the expanded air bubbles move to the discharge path 330, which has a relatively low pressure as no pressing force is generated by the component reinforcement plate 310, and are discharged to the exterior through the discharge path 330, which may prevent lifting from occurring in the mounting portion of the electronic component 200.

Furthermore, since the discharge path 330 is formed by removing the component adhesive layer 320, thereby reducing an adhesion area, it is preferable that the discharge path 330 is formed as a plurality of air tunnels 331 extending from the connection portion 220 and a fixing portion 230 to a nearest end. In the case of the discharge path 330 connected to the connection portion 220, considering that expanded air bubbles may merge with surrounding air bubbles, it is preferably formed in a central portion of the connection portion 220 to secure a contact area while also discharging air bubbles expanding in the vicinity.

FIG. 4A is a side view of a component reinforcement part illustrating a modified example of a discharge path, and FIG. 4B is an exploded perspective view of FIG. 4A.

As illustrated in FIG. 4, the discharge path 1330 of the modified example is formed with a first air hole 1331 penetrating both the component reinforcement plate 310 and the component adhesive layer 320 at a position corresponding to the connection portion 220, and a second air hole 1332 penetrating both the component reinforcement plate 310 and the component adhesive layer 320 at a position corresponding to a fixing portion 230, thereby discharging expanded air bubbles in a stacking direction.

In this case, for processability and removal of surrounding air bubbles, it is preferable that the first and second air holes 1331 and 1332 are formed to be in communication with each other. The discharge path 1330 of another embodiment is formed to penetrate both the component reinforcement plate 310 and the component adhesive layer 320, which may minimize the length of the flow path through which air bubbles are discharged, thereby enabling a more rapid discharge of air bubbles.

As illustrated in FIG. 5, a discharge path 2330 of another modified example is formed of a horizontal discharge path 2331, which is formed by removing the component adhesive layer 320 at positions corresponding to the connection portion 220 and a fixing portion 230, and a vertical discharge path 2332, which is formed by penetrating the component reinforcement plate 310 in a thickness direction so as to be in communication with one side of the horizontal discharge path 2331.

More specifically, the horizontal discharge path 2331 is formed to start at the positions of the connection portion 220 and the fixing portion 230 and extend a predetermined length to one side, and the vertical discharge path 2332 is formed at positions corresponding to the connection portion 220 and the fixing portion 230 so as to be in communication with the horizontal discharge path 2331. This configuration allows for rapid discharge of air bubbles in an axial direction in the portion where soldering is performed, while the horizontal discharge path 2331, having a certain length, reduces the travel path of expanded air bubbles around the connection portion 220 and the fixing portion 230 to enable smooth discharge.

In summary, the discharge path 330 of the printed circuit board 10 according to the present disclosure may be formed in various embodiments capable of discharging expanded air bubbles within the component adhesive layer 320. In this case, the discharge path 330 of the embodiment of FIGS. 1 to 3 allows the component reinforcement plate 310 to support the entire exposed region 131 to maintain supporting force, and is also formed to have a certain length to allow for smooth discharge of air bubbles around the connection portion 220 and a fixing portion 230. However, since the air bubbles are discharged while moving along the air tunnel 331, a rapid discharge may be difficult compared to a discharge path formed in an axial direction.

Furthermore, the discharge path 1330 of the modified example of FIG. 4 is formed as the first and second air holes 1331 and 1332 that connect both the connection portion 220 and a fixing portion 230. Although this may cause the largest reduction in the support area of the component reinforcement plate 310, the discharge of expanded air bubbles around the connection portion 220 and the fixing portion 230 is smooth, and the entire discharge path 1330 is open in an axial direction, allowing air bubbles to be rapidly discharged.

In addition, the discharge path 2330 of the other modified example of FIG. 5 is formed of the horizontal discharge path 2331, which is formed by removing the component adhesive layer 320 at the positions of the connection portion 220 and a fixing portion 230, and the vertical discharge path 2332, which communicates with the horizontal discharge path 2331 at the positions of the connection portion 220 and the fixing portion 230. This configuration minimizes the reduction in the support area while forming the vertical discharge path 2332, which opens in an axial direction at the positions of the connection portion 220 and the fixing portion 230 where soldering is directly performed, to allow for rapid discharge of air bubbles.

In this case, the horizontal discharge path 2331 is formed to extend a predetermined length to one side from the positions of the connection portion 220 and a fixing portion 230, so as to also allow for smooth discharge of air bubbles in the vicinity where soldering is directly performed.

That is, the discharge paths 330, 1330 and 2330 of different embodiments are the same in terms of purpose, function, and effect, but a support area of the component reinforcement plate 310 and an air bubble discharge route are different, such that a most suitable example may be selected in consideration of a type of the electronic component 200 to be mounted, a size and an installation position of the printed circuit board 10, and the like.

Therefore, a printed circuit board 10 according to the present disclosure includes a discharge path 330 configured to discharge an air bubble within a component adhesive layer 320 that expands during a mounting process of an electronic component 200. Accordingly, electrical connection stability between the electronic component 200 and a circuit layer 103 may be secured, and a component reinforcement part 300 may also be stably fixed, thereby improving reliability and durability of a product.

Furthermore, occurrence of defects due to a decrease in flatness of the printed circuit board 10 caused by an air bubble may be prevented. In addition, problems such as a decrease in tensile strength with the electronic component 200 and a decrease in electrical connection stability may be solved, thereby improving the reliability of an external device connected to the printed circuit board 10.

FIGS. 11 to 14 illustrate a pattern fuse part of a printed circuit board according to a second embodiment, wherein FIG. 11 is a plan view of the pattern fuse part, FIG. 12 is a bottom view of FIG. 8, FIG. 13 is a cross-sectional view taken along line XIII-XIII of FIG. 11, and FIG. 14 is a plan view of an adhesive layer of FIG. 11.

In the printed circuit board of the second embodiment, the remaining configuration, except for the pattern fuse part, is the same as that of the first embodiment. Therefore, only the pattern fuse part and the different configurations will be described.

A printed circuit board according to a second embodiment further comprises a fuse reinforcement part 400 formed on one side of the pattern fuse part 150 to support the pattern fuse part 150.

The fuse reinforcement part 400 comprises a fuse adhesive layer 420 attached to at least one surface of the first and second insulating layers 101 and 102 of the pattern fuse part 150, and a fuse reinforcement plate 410 attached to the fuse adhesive layer 420.

The fuse adhesive layer 420 is formed in a region other than a position corresponding to the fusible portion 151, thereby forming an air gap 425 at the position corresponding to the fusible portion 151. That is, as illustrated in FIG. 11, the fuse adhesive layer 420 includes a fuse adhesive layer body 421 having a quadrangular ring shape that surrounds the air gap 425.

The fuse reinforcement plate 410 is formed of the same material as the component reinforcement plate 310.

The fuse reinforcement part 400 includes a fuse reinforcement part fixing hole 430 formed to penetrate the fuse reinforcement part 400. That is, the fixing hole 430 is formed to penetrate the pattern fuse part 150, the fuse adhesive layer 420, and the fuse reinforcement plate 410. The fixing hole 430 is formed in a number and at a position necessary for fixing the pattern fuse part 150. A boss or the like, formed on a counterpart to which the pattern fuse part 150 is fixed, is inserted into the fixing hole 430 and fused, thereby achieving fixation.

As described above, in the printed circuit board of the second embodiment, by including the fuse reinforcement part 400 on the pattern fuse part 150, the flatness of the pattern fuse part may be maintained, and it may be firmly fixed to a counterpart. In addition, by providing an air gap 421, changes in fusing characteristics and current-carrying characteristics that may be caused by the attachment of the fuse adhesive layer 420 to the fusible portion 151 can be prevented. In particular, when the fusible portion 151 melts, this may prevent the fuse adhesive layer 420 from being carbonized due to high temperatures and affecting other circuits.

While preferred embodiments of the present disclosure have been described above as examples, the scope of the present disclosure is not limited to such specific embodiments, and it should be understood that various modifications within the scope of the appended claims are included in the protection scope of the present disclosure.

## Claims

1. A printed circuit board comprising:
a substrate portion (100) comprising a circuit layer (103) disposed between first and second insulating layers (101, 102);
an electronic component (200) mounted in an exposed region (131) where the circuit layer (103) is exposed by removing a portion of the first insulating layer (101); and
a component reinforcement part (300) attached to the second insulating layer (102) in the exposed region (131) and configured to support the electronic component (200),
wherein the component reinforcement part (300) comprises a component reinforcement plate (310) bonded to the second insulating layer (102) of the exposed region (131), a component adhesive layer (320) formed between the second insulating layer (102) and the component reinforcement plate (310), and a discharge path (330, 1330, 2330) configured to discharge an air bubble within the component adhesive layer (320),
wherein the substrate portion (100) further comprises a pattern fuse part (150) in which a portion of the circuit layer (103) is formed to function as a fuse, and
wherein the pattern fuse part (150) comprises a fusible portion (151) configured to melt faster than other parts of the circuit layer (103) at or above a predetermined current.

2. The printed circuit board of claim 1,
wherein the electronic component (200) comprises a connection portion (220) configured to be electrically connected by soldering to the circuit layer (103) exposed in the exposed region (131), and
wherein the discharge path (330, 1330, 2330) is formed at a position corresponding to the connection portion (220).

3. The printed circuit board of claim 2,
wherein the discharge path (330, 1330, 2330) is formed as an air tunnel (331) in which the component adhesive layer (320) is removed from a position of the connection portion (220) to one side end of the exposed region (131).

4. The printed circuit board of claim 3,
wherein a fixing circuit (132), to which the electronic component (200) is fixed by soldering, is formed in the exposed region (131), and
wherein the discharge path (330, 1330, 2330) is additionally formed at a position corresponding to the fixing circuit (132).

5. The printed circuit board of claim 1,
wherein the pattern fuse part (150) further comprises:
connection pads (152) formed at both ends of the fusible portion (151).

6. The printed circuit board of claim 5,
wherein a width of the connection pads (152) is greater than a width of the fusible portion (151).

7. The printed circuit board of claim 6,
wherein at least one of the first insulating layer (101) or the second insulating layer (102) is not formed on the connection pads (152), such that the connection pads (152) are exposed to an exterior.

8. The printed circuit board of claim 7,
wherein a protective coating liquid is applied on the connection pads (152).

9. The printed circuit board of claim 5,
wherein the pattern fuse part (150) further comprises:
an interference prevention part (153) surrounding the fusible portion (151), wherein the interference prevention part (153) is a region from which the circuit layer (103) has been removed.

10. The printed circuit board of claim 5,
wherein the pattern fuse part (150) further comprises:
a concentrated fusing portion (154) formed by an opening in at least one of the first insulating layer (101) or the second insulating layer (102) over at least a portion of the fusible portion (151).

11. The printed circuit board of claim 10, wherein a protective coating liquid is applied to an open surface of the concentrated fusing portion (154).

12. The printed circuit board of claim 5,
wherein the pattern fuse part (150) further comprises:
an overflow prevention part (155) formed as a closed curve surrounding the pattern fuse part (150) and formed to protrude from at least one of the first insulating layer (101) or the second insulating layer (102).

13. The printed circuit board of claim 2, wherein the discharge path (330, 1330, 2330) is formed as an air hole (1331, 1332) that penetrates the component reinforcement plate (310) and the component adhesive layer (320) at a position of the connection portion(220).

14. The printed circuit board of claim 2, wherein the discharge path (330, 1330, 2330) comprises:
a horizontal discharge path (2331) formed by removing the component adhesive layer (320) at a position of the connection portion; and
a vertical discharge path (2332) formed to penetrate the component reinforcement plate (310) so as to be in communication with the horizontal discharge path (2331).

15. The printed circuit board of claim 2, wherein the discharge path (330, 1330, 2330) comprises:
a horizontal discharge path (2331) formed by removing the component adhesive layer (320) at a position of the connection portion; and
a vertical discharge path (2332) formed to penetrate the component reinforcement plate (310) so as to be in communication with the horizontal discharge path (2331).

16. The printed circuit board of claim 1, further comprising: a fuse reinforcement part (400) formed on one side of the pattern fuse part (150) to support the pattern fuse part (150), wherein the fuse reinforcement part (400) comprises:
a fuse adhesive layer (420) attached to at least one surface of the first and second insulating layers (101, 102) of the pattern fuse part (150); and
a fuse reinforcement plate (410) attached to the fuse adhesive layer (420).

17. The printed circuit board of claim 16, wherein the fuse adhesive layer (420) is formed in a region other than a position corresponding to the fusible portion (151), thereby forming an air gap (425) at the position corresponding to the fusible portion (151).

18. The printed circuit board of claim 16, wherein the fuse reinforcement part (400) further comprises:
a fuse reinforcement part fixing hole (430) formed to penetrate the fuse reinforcement part (400).
